# FASCICULE DE BREVET EUROPEEN

(11) **EP 0 675 547 B1**
(45) Date de publication et mention de la délivrance du brevet: **12.05.1999**
(21) Numéro de dépôt: 95410022.8
(22) Date de dépôt: 24.03.1995
(51) Int. Cl.: H01L 29/788, G11C 16/06, G11C 16/04, H01L 21/336

(54) **Cellule mémoire électriquement programmable**
Elektrisch programmierbare Speicherzelle
Electrically programmable memory cell

(30) Priorité: 30.03.1994 FR 9404146
(43) Date de publication de la demande: 04.10.1995
(73) Titulaire: STMicroelectronics S.A., 94250 Gentilly (FR)
(72) Inventeur: Papadas, Constantin, F-38000 Grenoble (FR); Guillaumot, Bernard, F-38120 Le Fontanil (FR)
(74) Mandataire: de Beaumont, Michel

(56) Documents cités:
- EP-A- 0 193 841
- EP-A- 0 473 129
- EP-A- 0 597 722
- DE-A- 3 345 173
- US-A- 4 203 158
- US-A- 4 804 637
- US-A- 5 267 194
- PATENT ABSTRACTS OF JAPAN vol. 14 no. 22 (E-874) ,17 Janvier 1990 & JP-A-01 262669 (SONY CORP)
- PATENT ABSTRACTS OF JAPAN vol. 11 no. 227 (E-526) ,23 Juillet 1987 & JP-A-62 043179 (SEIKO EPSON CORP)
- IEEE ELECTRON DEVICE LETTERS, vol. 11, no. 11, Novembre 1990 NEW YORK, USA, pages 514-516, XP 000148742 SAMEER HADDAD ET AL. 'AN INVESTIGATION OF ERASE-MODE DEPENDENT HOLE TRAPPING IN FLASH EEPROM MEMORY CELL'
- PATENT ABSTRACTS OF JAPAN vol. 13 no. 2 (E-700) ,6 Janvier 1989 & JP-A-63 215079 (OKI ELECTRIC IND CO LTD)

## Description

La présente invention concerne le domaine des mémoires en circuit intégré et plus particulièrement une cellule de mémoire morte électriquement programmable (couramment désignée par le sigle EPROM - Electrically programable Read-Only Memory) et électriquement effaçable (EEPROM).

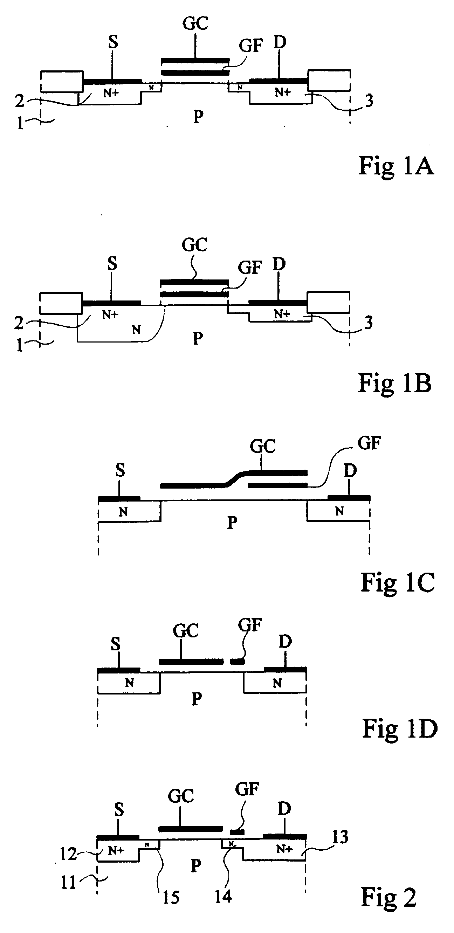

Les figures 1A à 1D sont des vues en coupe schématique de divers types de cellules mémoire connues.

La figure 1A représente une cellule EPROM ayant l'allure générale d'un transistor MOS dans lequel une grille flottante est intercalée entre la grille de commande et le substrat. Cette cellule comprend dans un substrat 1 de type P des régions de source et de drain 2 et 3 de type N ayant par exemple l'allure représentée dite LDD, c'est-à-dire que l'on trouve de part et d'autre de la région de canal située sous la grille une région de type N plus faiblement dopée. La région de canal est surmontée d'une première grille isolée dite grille flottante GF elle-même surmontée d'une seconde grille isolée dite grille de commande GC. Classiquement, la source et le substrat sont au potentiel de la masse.

Pour la programmation d'une telle cellule, la grille de commande et le drain sont portés à des potentiels positifs, par exemple respectivement 12 volts et 6 volts. Il en résulte la formation d'une zone de canal inversée sous la grille et une circulation d'électrons de la source au drain. Une barrière de potentiel apparaît au voisinage de la région de drain et le courant d'électrons dans cette région crée ce qu'il est convenu d'appeler des électrons chauds qui sont injectés dans la grille flottante qui se trouve alors être chargée négativement.

Ensuite, quand on cherche à faire passer du courant dans le transistor MOS ayant pour grille la grille de commande GC, selon que la grille flottante GF a été chargée négativement ou non, il faudra appliquer une tension de grille plus ou moins élevée pour rendre le transistor passant. L'état d'une cellule peut être déterminé au cours d'une opération de lecture en appliquant une tension de grille telle que les cellules non-programmées soient passantes et les cellules programmées restent bloquées. En d'autres termes, par l'opération de programmation susmentionnée, on a modifié la "tension de seuil" du transistor.

La cellule décrite ci-dessus en relation avec la figure 1A est normalement effacée par irradiation par des rayons ultraviolets. Alors, les électrons acquièrent une énergie suffisante pour surmonter la barrière de l'oxyde et ainsi les électrons stockés dans cette grille flottante sont éliminés.

Diverses variantes de cette cellule EPROM ont été imaginées. Certaines de ces variantes sont illustrées en figures 1B à 1D.

La figure 1B diffère de la figure 1A par le dopage de la région de source. Ce dopage est progressif de façon que la jonction source-substrat puisse supporter une tension relativement élevée. Cette cellule est effaçable électriquement en appliquant une tension élevée à la source tandis que la grille de commande est à la masse et que le drain est flottant.

Un inconvénient de ce mode d'effacement est que, si la durée d'effacement est trop longue, on peut arriver à créer un déficit d'électrons dans la grille flottante qui se trouve alors chargée positivement au lieu de revenir à un état neutre. Le canal peut alors être perpétuellement passant et, lors d'une lecture, on ne sait plus identifier la cellule qui conduit. Divers circuits ont été imaginés pour pallier cet inconvénient.

La figure 1C illustre un moyen structurel pour éviter l'inconvénient susmentionné. La grille flottante GF couvre alors seulement une partie de la longueur de canal ce qui fait que, même si elle demeure légèrement chargée positivement, il restera une région de canal bloquée, mais cette structure entraîne une augmentation de surface de cellule.

La figure 1D représente une autre variante décrite dans un article de Mizutani et Makita paru dans IEEE Transactions on Electron Devices, vol. ED-34, N° 6, juin 1987, pp 1297-1303 et dans JP-A-63 215 079. Dans cette structure, la grille flottante recouvre une partie seulement de la zone de canal et n'est pas surmontée par la grille de commande. L'article susmentionné décrit une réalisation de cette grille flottante à partir d'un espaceur en silicium polycristallin formé sur un côté de la grille de commande.

Les figures 1A à 1D ci-dessus sont extrêmement schématiques et les dispositifs existants présentent de nombreuses variantes par rapport à ce qui a été décrit, notamment en ce qui concerne l'allure des régions de source et de drain, de type LDD ou non, de type à gradient de dopage (comme cela est représenté en figure 1B) ou non, et en ce qui concerne les connexions. En particulier, dans les figures, on a représenté au-dessus de chaque région de source et de drain une métallisation de source et une métallisation de drain. De façon classique, dans un réseau de mémoire, les diverses cellules mémoire ont une source commune. Il n'y aura donc pas de métallisation de source sur chaque cellule.

On connaît aussi dans l'art antérieur des cellules EPROM dans lesquelles la grille flottante s'étend non seulement au-dessus du canal mais aussi au-dessus d'une extension de la source et/ou du drain (voir JP-A-1/262 669, US-A-4 804 637, EP-A-597 722, US-A-4 203 158, DE-A-3 345 173, US-A-5 267 194, EP-A-473 129 et IEEE Electron Device Letters, vol. 11, N° 11, novembre 1990, pp 514-516. Dans la plupart de ces documents, il existe aussi une superposition au moins partielle de la grille flottante et de la grille de commande.

Le document EP-A-193 841 décrit en figure 9 une cellule EPROM dans laquelle la grille flottante est latérale par rapport à la grille de commande et s'étend au-dessus d'un prolongement faiblement dopé du drain. Les épaisseurs d'isolant sous la grille flottante et sous la grille de commande sont identiques et la charge de la grille flottante s'effectue par injection de porteurs chauds.

Si on considère de façon générale le fonctionnement des cellules mémoire décrites précédemment, un point commun entre toutes ces cellules est que les porteurs chauds générés dans le canal auront un effet dans au moins un de leurs modes de fonctionnement. Ces cellules présentent toutes plusieurs des inconvénients suivants.
1. A chaque opération de lecture, il se produit inévitablement une création de porteurs chauds dans le canal, au voisinage du drain, et une injection parasite de porteurs (électrons) dans la grille. Il en résulte une accumulation de charge dans les grilles flottantes et les cellules non-programmées se mettent, après un certain nombre d'opérations de lecture, à ressembler à des cellules programmées. En d'autres termes, les tensions de seuil des cellules programmées et non-programmées se rapprochent et deviennent plus difficiles à différencier.
2. L'opération de programmation nécessite le passage d'un courant relativement important entre source et drain sous, par exemple, une tension de 12 volts. Dans les circuits intégrés classiques, on connaît des moyens pour fournir à partir d'une tension d'alimentation basse, par exemple 3 ou 5 volts, une tension plus élevée, de l'ordre de 12 volts. Ces systèmes sont des systèmes dits à pompe de charge. Toutefois, ils présentent l'inconvénient d'avoir des impédances de sortie élevées et donc de ne pas se prêter à la circulation de courants importants. Il est donc généralement nécessaire de prévoir, pour la programmation, une source de tension haute externe au circuit intégré.
3. Les opérations de programmation et d'effacement sont des opérations par tout ou rien. Ces cellules ne se prêtent donc pas à la mémorisation de valeurs analogiques.
   D'autres inconvénients sont plus particulièrement liés aux cellules mémoire effaçables électriquement, c'est-à-dire présentant une région de source à profil de diffusion spécifique telle qu'illustrée en figure 1B. Ces inconvénients sont les suivants.
4. Etant donné le type de formation des régions de source, et éventuellement de drain, la profondeur de diffusion des atomes dopants de la source sous la grille est mal contrôlée et donc la longueur efficace de la région de canal est variable, ce qui réagit sur la tension de seuil.
5. L'injection de porteurs chauds dans la grille pendant l'opération d'effacement sous des tensions élevées risque de détériorer l'oxyde de grille. Ces cellules sont donc fragiles.
6. Comme on l'a indiqué précédemment, on a un risque d'inversion de la polarité de grille flottante ce qui oblige à prendre des précautions particulières si l'on ne veut pas que la cellule soit en permanence conductrice.

Un objet de la présente invention est de prévoir une cellule mémoire évitant tous les inconvénients susmentionnés des cellules classiques, y compris des cellules effaçables électriquement.

Un autre objet de la présente invention est de prévoir une telle cellule dont la surface ne soit pas plus grande que celle d'une cellule mémoire classique.

Un autre objet de la présente invention est de prévoir une telle cellule qui ne soit pas plus complexe à fabriquer qu'une cellule mémoire classique.

Pour atteindre ces objets, la présente invention prévoit un nouveau type de cellule mémoire à grille flottante, dans laquelle le phénomène de mémorisation ne repose plus sur une modulation de la tension de seuil d'un transistor MOS mais sur une modulation de la résistance de drain de ce transistor MOS et dans laquelle la grille flottante est chargée et déchargée par effet tunnel et n'est pas soumise à l'influence de porteurs chauds générés dans la zone de canal.

Plus particulièrement, la présente invention prévoit une cellule mémoire électriquement programmable comprenant au-dessus d'une région de canal d'un premier type de conductivité une grille de commande isolée et, de part et d'autre, des régions de source et de drain du deuxième type de conductivité, au moins la région de drain comprenant, au voisinage du canal, une zone à faible niveau de dopage. Une grille flottante isolée recouvre au moins en partie cette zone à faible niveau de dopage et est formée exclusivement sur cette partie. L'épaisseur d'isolant sous la grille flottante est inférieure à l'épaisseur d'isolant sous la grille de commande et est suffisamment faible pour que l'injection des porteurs de charge puisse se produire par effet tunnel.

Cette grille flottante isolée peut aussi surmonter une extension de la région de source ou encore entourer complètement la grille de commande.

Selon un mode de réalisation de la présente invention, l'isolant sous la grille flottante est de l'oxyde de silicium d'une épaisseur comprise entre 8 et 12 nm, par exemple voisine de 10 nm.

Selon un mode de réalisation de la présente invention, l'isolant de la grille de commande est de l'oxyde de silicium sensiblement deux fois plus épais que l'isolant de la grille flottante.

Un procédé de programmation d'une cellule mémoire selon l'invention consiste à connecter drain, source et substrat à la masse et à appliquer une impulsion de tension à la grille de commande, positive quand le substrat est de type P.

Un procédé d'effacement d'une cellule mémoire selon l'invention consiste à connecter drain, source et substrat à la masse et à appliquer une impulsion de tension à la grille de commande, négative quand le substrat est de type P.

Une variante de procédé d'effacement d'une cellule mémoire selon l'invention consiste à connecter la grille de commande et le substrat à la masse et à appliquer une impulsion de tension au drain et à la source, positive quand le substrat est de type P.

Un procédé de fabrication d'une cellule mémoire électriquement programmable selon l'invention comprend les étapes consistant à délimiter sur un substrat conducteur une région active, recouvrir cette région active d'un oxyde de grille et délimiter une région de grille sensiblement au centre de ladite région active, éliminer l'oxyde de grille partout sauf sous la région de grille, former un oxyde mince sur le substrat et sur et autour de la grille, implanter un dopant du deuxième type de conductivité à faible niveau de dopage, former des espaceurs en matériau conducteur de part et d'autre de la grille, et implanter un dopant de source et de drain du deuxième type de conductivité à fort niveau de dopage.

Selon un mode de réalisation de la présente invention, ce procédé comprend en outre l'étape consistant à éliminer un espaceur d'un côté de la grille.

Selon un mode de réalisation de la présente invention, l'étape d'implantation d'un dopant à faible niveau de dopage précède ou suit l'étape d'enlèvement de l'oxyde de grille et l'étape de formation de l'oxyde mince.

Selon un mode de réalisation de la présente invention, la grille de commande et les espaceurs sont en silicium polycristallin dopé.

Selon un mode de réalisation de la présente invention, l'oxyde mince est formé par oxydation thermique jusqu'à une épaisseur comprise entre 8 et 12 nm.

Ces objets, caractéristiques et avantages ainsi que d'autres de la présente invention seront exposés en détail dans la description suivante de modes de réalisation particuliers faite, à titre non-limitatif, en relation avec les figures jointes parmi lesquelles :
les figures 1A à 1D illustrent très schématiquement divers types de cellules mémoire électriquement programmables et éventuellement électriquement effaçables selon l'art antérieur ;
la figure 2 représente très schématiquement une cellule mémoire selon la présente invention ;
les figures 3A à 3D illustrent à titre d'exemple un mode de réalisation de procédé de fabrication d'une cellule mémoire selon la présente invention ; et
la figure 4 représente à titre d'exemple une vue de dessus d'un mode de réalisation d'un réseau de cellules mémoire selon la présente invention.

Comme le représente la figure 2, une cellule mémoire selon la présente invention a une structure similaire à celle d'un transistor MOS de type LDD, c'est-à-dire un transistor MOS constitué à partir d'un substrat semiconducteur 11 d'un premier type de conductivité, par exemple le type P, muni de régions de source et de drain 12 et 13 et d'une grille de commande isolée GC. Au moins la région de drain comprend une portion 14, proche du canal du transistor MOS, à plus faible niveau de dopage. Au moins une partie de cette région de drain 14 à plus faible niveau de dopage est revêtue d'une grille flottante GF et l'isolant de cette grille flottante est environ deux fois plus mince que l'isolant de la grille de commande.

Dans la représentation de la figure 2, la région de source 12 comprend aussi une portion à plus faible niveau de dopage 15 proche de la région de canal mais, comme on le verra ci-après, ceci n'est pas nécessaire au fonctionnement du dispositif selon la présente invention et résulte simplement d'un procédé de fabrication particulier. De même, en figure 2, on a représenté des métallisations de source et de drain mais, comme on l'a indiqué précédemment, il n'existe généralement pas de métallisation de source pour chaque cellule d'un réseau de mémoire.

Selon la présente invention, la grille flottante est formée exclusivement au-dessus d'une partie de la région de drain et ne s'étend pas au-dessus d'une partie de la région de canal.

Il en résulte une différence radicale de fonctionnement entre la cellule mémoire selon l'invention et les cellules selon l'art antérieur. D'abord, on comprendra que la charge ou la non-charge de la grille flottante aura cette fois-ci une action sur la résistance de drain et non plus sur la tension de seuil du transistor MOS associé à la grille de commande. D'autre part, les phénomènes physiques liés au processus d'écriture (programmation) selon l'invention sont radicalement différents de ceux des cellules de l'art antérieur.

Dans l'art antérieur, comme on l'a vu précédemment, la programmation, c'est-à-dire l'injection d'électrons dans la grille flottante, résulte de la création de porteurs chauds dans la partie du canal voisine du drain. Ici, l'injection d'électrons dans la grille flottante résulte d'un effet tunnel (Fowler-Nordheim). Plus particulièrement, pour la programmation d'une cellule selon la présente invention, on met à la masse le drain, la source et le substrat, et une impulsion de tension est appliquée à la grille de commande GC, par exemple sous un potentiel de l'ordre de 10 à 12 volts. L'excès d'électrons généré dans le substrat sous la grille de commande passera par la zone d'extension de drain 14 et à travers la couche d'oxyde tunnel vers la grille flottante. On notera que ce processus n'implique pas de circulation de courant.

Il convient bien entendu que l'épaisseur de l'isolant, généralement de l'oxyde de silicium, sous la grille flottante soit suffisamment faible pour que le transfert d'électrons du substrat à la grille par effet tunnel puisse se produire. En pratique, ceci conduit à des épaisseurs d'oxyde situées dans la plage de 8 à 12 nm, typiquement 10 nm. Ces épaisseurs très faibles sont utilisables sans inconvénient dans la cellule selon la présente invention puisque cet oxyde tunnel n'est en aucun cas soumis à un bombardement de porteurs chauds.

Symétriquement, l'opération d'effacement s'effectuera en maintenant le drain, la source et le substrat à la masse et en appliquant à la grille de commande une impulsion négative, par exemple sous un potentiel de l'ordre à -8 à -12 volts. A titre de variante, on pourra mettre le substrat et la grille de commande à la masse et appliquer une impulsion positive à la source et au drain.

La lecture se fera en appliquant un potentiel sur le drain et un potentiel sur la grille de commande pour rendre le canal passant et l'on pourra ainsi observer, pour des tensions données, des valeurs de courant liées au potentiel de la grille flottante qui détermine la valeur de la résistance de drain ou au moins de la partie 14 de la région de drain située sous la grille flottante.

Dans ce qui précède, on a proposé une cellule mémoire à grille flottante située au-dessus d'une extension de la région de drain. L'homme de métier notera que cette grille flottante peut aussi s'étendre au-dessus d'une extension de la région de source ou plus généralement entourer complètement la grille de commande.

La cellule mémoire à grille flottante selon l'invention a une surface qui n'est pas supérieure à celle d'un transistor MOS ou d'une cellule EPROM classique et pallie tous les inconvénients susmentionnés de l'art antérieur.
1. Au cours de la lecture, si une génération d'électrons chauds se produit dans la région du canal voisine de la région de drain, ces électrons seront transférés vers la grille de commande et non pas vers la grille flottante et ne modifieront donc pas l'état de charge ou de décharge de cette grille flottante.
2. Les processus de programmation et d'effacement de la grille flottante impliquent comme dans l'art antérieur l'utilisation de tensions plus élevées que les tensions habituelles de fonctionnement, c'est-à-dire les tensions de 10 à 12 volts pour des tensions de fonctionnement (lecture) qui sont par exemple de 1,8 ou 3,3 volts, mais pratiquement pas de circulation de courant. Il est donc possible d'utiliser un circuit intégré comprenant une seule source d'alimentation associée, à l'intérieur du circuit intégré, à des systèmes à pompe de charge qui n'auront pas à fournir de courant important.
3. Les phénomènes mis en oeuvre pour la programmation et l'effacement de la grille flottante sont des phénomènes essentiellement proportionnels à l'amplitude et à la durée de l'impulsion de tension appliquée sur la grille de commande. Il est donc possible de procéder à une programmation sélective qui entrainera une variation de résistance sélectionnée à l'intérieur d'une plage déterminée. La présente invention se prête donc à une mémorisation de valeurs analogiques.
4. La définition de la longueur électrique sous le canal est aussi bonne que pour tout transistor MOS classique.
5. Pendant l'effacement, on ne produira pas de porteurs chauds sous la grille flottante. Il n'y a donc pas de risque de détérioration de l'oxyde tunnel (par ailleurs, l'oxyde sous la grille de commande sera généralement plus épais et ne risque pas non plus d'être endommagé).
6. L'existence d'une charge sur la grille flottante ne modifie pas la conductivité du canal et n'entraîne donc pas le risque d'avoir un transistor en permanence à l'état passant.

On va en outre montrer qu'un autre avantage de la cellule mémoire selon la présente invention est qu'elle est parfaitement compatible avec les procédés classiques de fabrication de transistors MOS et que sa fabrication n'est pas plus complexe, sinon plus simple, que celle d'une cellule mémoire à grilles superposées.

Un exemple d'une séquence possible d'étapes de fabrication sera décrit rapidement car ces étapes, prises isolément, sont relativement classiques, ne constituent qu'un mode de réalisation possible d'une structure selon la présente invention, et ont été partiellement décrites dans l'article susmentionné de Mizutani et Makita.

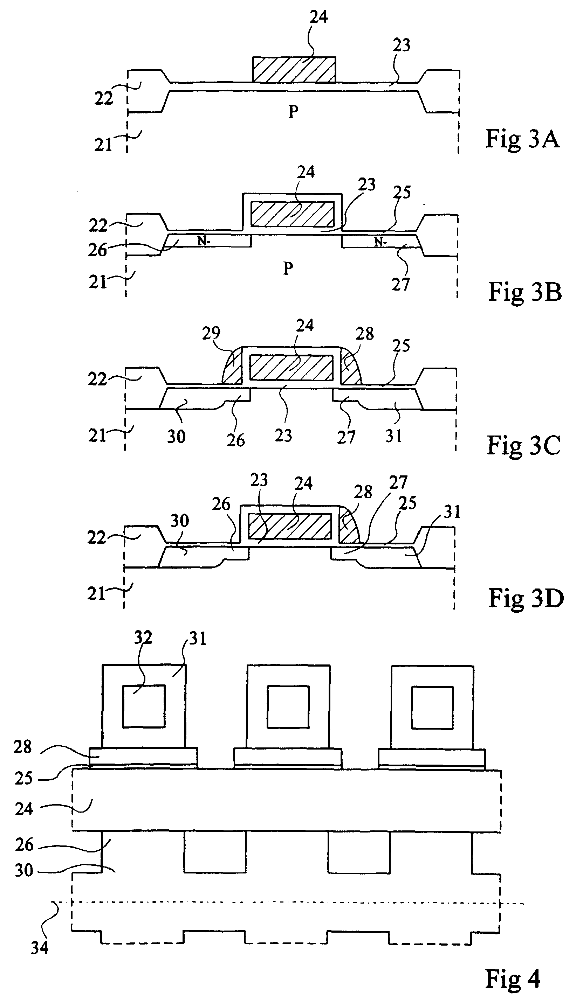

La figure 3A représente une structure à une étape intermédiaire classique de fabrication de transistor MOS. Sur un substrat 21 de type P est délimitée une zone active par une région d'oxyde épais 22. Cette région active est revêtue d'une couche d'oxyde mince 23, généralement formée par oxydation thermique, qui servira d'oxyde de grille de commande. Cet oxyde de grille est revêtu d'une région de grille 24 généralement formée par dépôt et gravure d'une couche de silicium polycristallin dopé de type N⁺.

Comme le représente la figure 3B, on élimine ensuite l'oxyde 23 par gravure et on réoxyde l'ensemble de la structure par oxydation thermique jusqu'à obtenir un oxyde 25 de l'épaisseur voulue pour la formation de l'oxyde tunnel situé sous la grille flottante.

Lors de l'une des étapes comprises entre celles illustrées en figures 3A et 3B, on procède à une implantation d'un dopant de type N, couramment du phosphore, pour former des régions de source et de drain faiblement dopées 26 et 27.

Ensuite, comme le représente la figure 3C, on forme par tout procédé connu des espaceurs en un matériau conducteur, couramment en silicium polycristallin dopé de type N⁺, pour former des espaceurs 28 et 29 de part et d'autre de la grille de commande 24. Ces espaceurs sont isolés de la grille de commande et du substrat par la couche d'oxyde mince 25. Une fois les espaceurs formés, on procède à une deuxième implantation ionique à plus fort niveau de dopage pour former des régions de source et de drain 30 et 31, plus fortement dopées que les régions 26 et 27, comme cela est classique lors de la formation de transistors MOS de type LDD.

Enfin, si on le souhaite, on élimine, comme le représente la figure 3D, l'espaceur 29 situé du côté source par masquage et gravure sélective du matériau conducteur constituant cet espaceur (par exemple du silicium polycristallin) par rapport à l'oxyde de silicium constituant la couche 25 et l'oxyde épais 22. On procèdera ensuite aux étapes finales classiques d'ouverture de contacts au-dessus de la région de drain 31, de formation de métallisation ou de siliciure pour ces contacts, puis aux opérations finales d'interconnexion et d'isolement.

La figure 3D représente donc bien une structure de cellule mémoire remplissant les fonctions de celle de la figure 2. Les régions 30 et 26 correspondent à la région 12 de source, la région 31 correspond à la région de drain 13, la région 27 correspond à la région 14 d'extension de drain sous la grille flottante, l'espaceur 28 correspond à la grille flottante GF, et la région 24 correspond à la grille de commande GC.

Le procédé illustré en figures 3A à 3D ne constitue qu'un exemple de procédé utilisable pour la réalisation d'un dispositif selon la présente invention et de plus, ce procédé est susceptible de nombreuses variantes couramment mises en oeuvre pour la fabrication de transistors MOS.

De préférence, dans le cas où le substrat a un niveau de dopage de l'ordre de 5.10¹⁶ à 5.10¹⁷ atomes/cm³, le niveau de dopage des régions faiblement dopées 26 et 27 est de l'ordre de 5.10¹⁷ à 10¹⁸ atomes/cm³, l'épaisseur de l'oxyde tunnel 25 est de l'ordre de 8 à 12 nm, typiquement 10 nm, l'épaisseur de l'oxyde 23 sous la grille de commande est typiquement de 20 nm (environ deux fois l'épaisseur de l'isolant sous la grille flottante).

Les inventeurs ont constaté par simulation qu'avec une cellule de ce type, pour une tension de grille de lecture donnée, par exemple 3 V, on obtient un rapport supérieur à 2 entre le courant dans les cellules programmées et le courant dans les cellules non-programmées. Ceci est meilleur que pour la plupart des cellules classiques pour lesquelles ce rapport dépasse rarement 1,5.

La figure 4 représente un exemple de vue de dessus d'une partie d'un assemblage matriciel de cellules mémoire selon la présente invention. Dans cette figure, on a indiqué par de mêmes références des régions correspondant à celles de la figure 3D. Ainsi, chaque cellule mémoire a un drain 31 muni d'un contact de drain 32, une grille flottante 28, une grille de commande 24 et une source 26-30. Ces cellules se répètent dans le sens transversal de la figure et sont dupliquées par symétrie autour d'un axe horizontal 34. La grille de commande 24 est commune à toutes les cellules d'une même rangée et la source 30 est commune à toutes les cellules de deux rangées adjacentes situées de part et d'autre de l'axe de symétrie 34.

A nouveau, de nombreuses variantes de conception d'un réseau de cellules mémoire selon l'invention pourront être réalisées par l'homme de l'art.

## Revendications

1. Cellule mémoire électriquement programmable comprenant au-dessus d'une région de canal (11) d'un premier type de conductivité une grille de commande (GC) et, de part et d'autre, des régions de source (12) et de drain (13) du deuxième type de conductivité, au moins la région de drain comprenant, au voisinage du canal, une zone (14) à faible niveau de dopage, une grille flottante (GF) recouvrant au moins en partie ladite zone (14) à faible niveau de dopage et étant formée exclusivement sur cette partie, caractérisée en ce que l'épaisseur d'isolant sous la grille flottante est inférieure à l'épaisseur d'isolant sous la grille de commande et est suffisamment faible pour que l'injection de charges puisse se produire par effet tunnel.

2. Cellule mémoire selon la revendication 1, la région de source comprenant aussi, au voisinage du canal, une zone (26) à faible niveau de dopage, caractérisée en ce que ladite zone (26) à faible niveau de dopage est aussi au moins en partie surmontée d'une grille flottante isolée (GF).

3. Cellule mémoire selon la revendication 2, caractérisée en ce que ladite grille flottante isolée (GF) entoure complètement la grille de commande.

4. Cellule mémoire selon l'une quelconque des revendications 1 à 3, caractérisée en ce que l'isolant sous la grille flottante est de l'oxyde de silicium d'une épaisseur comprise entre 8 et 12 nm.

5. Cellule mémoire selon la revendication 4, caractérisée en ce que ladite épaisseur est voisine de 10 nm.

6. Cellule mémoire selon la revendication 4, caractérisée en ce que l'isolant sous la grille de commande est de l'oxyde de silicium sensiblement deux fois plus épais que l'isolant sous la grille flottante.

7. Procédé de programmation d'une cellule mémoire selon l'une quelconque des revendications 1 à 6, caractérisé en ce qu'il consiste à connecter drain, source et substrat à la masse et à appliquer une impulsion de tension à la grille de commande, positive quand le substrat est de type P.

8. Procédé d'effacement d'une cellule mémoire selon l'une quelconque des revendications 1 à 6, caractérisé en ce qu'il consiste à connecter drain, source et substrat à la masse et à appliquer une impulsion de tension à la grille de commande, négative quand le substrat est de type P.

9. Procédé d'effacement d'une cellule mémoire selon l'une quelconque des revendications 1 à 6, caractérisé en ce qu'il consiste à connecter la grille de commande et le substrat à la masse et à appliquer une impulsion de tension au drain et à la source, positive quand le substrat est de type P.

10. Procédé de fabrication d'une cellule mémoire électriquement programmable selon l'une quelconque des revendications 1 à 6, caractérisé en ce qu'il comprend les étapes suivantes :
délimiter sur un substrat semiconducteur (21) une région active, recouvrir cette région active d'un oxyde de grille (23) et délimiter une région de grille (24) sensiblement au centre de ladite région active,
éliminer l'oxyde de grille (23) partout sauf sous la région de grille (24),
former un oxyde mince (25) sur le substrat et sur et autour de la grille (24),
implanter un dopant du deuxième type de conductivité à faible niveau de dopage,
former des espaceurs (28, 29) en matériau conducteur de part et d'autre de la grille, et
implanter un dopant de source et de drain du deuxième type de conductivité à fort niveau de dopage.

11. Procédé selon la revendication 10, caractérisé en ce qu'il comprend en outre l'étape consistant à éliminer un espaceur d'un côté de la grille.

12. Procédé selon la revendication 10, caractérisé en ce que l'étape d'implantation d'un dopant à faible niveau de dopage précède ou suit l'étape d'enlèvement de l'oxyde de grille et l'étape de formation de l'oxyde mince.

13. Procédé selon la revendication 10, caractérisé en ce que la grille de commande et les espaceurs sont en silicium polycristallin dopé.

14. Procédé selon la revendication 10, caractérisé en ce que l'oxyde mince (25) est formé par oxydation thermique jusqu'à une épaisseur comprise entre 8 et 12 nm.

## Patentansprüche

1. Elektrisch programmierbare Speicherzelle, welche über einem Kanalbereich (11) eines ersten Leitfähigkeitstyps ein Steuer-Gate (GC) und zu beiden Seiten einen Source-Bereich (12) und einen Drain-Bereich (13) vom zweiten Leitfähigkeitstyp aufweist, wobei wenigstens der Drain-Bereich benachbart dem Kanal eine Zone (14) von niedrigem Dotierungspegel aufweist und ein flottierendes bzw. schwimmendes Gate (GF) die genannte Zone (14) niedrigen Dotierungsniveaus wenigstens teilweise überdeckt und ausschließlich über diesem Teil gebildet ist,
dadurch gekennzeichnet, daß die Dicke der Isolierschicht unter dem flottierenden Gate kleiner als die Isolierschichtdicke unter dem Steuer-Gate und hinreichend gering ist, daß es zu einer Ladungsträgerinjektion mittels Tunneleffekt kommen kann.

2. Speicherzelle nach Anspruch 1, bei welcher auch der Source-Bereich benachbart dem Kanal eine Zone (26) niedrigen Dotierungspegels aufweist,
dadurch gekennzeichnet, daß die genannte Zone (26) niedrigen Dotierungspegels auch wenigstens teilweise von einem isolierten flottierenden Gate (GF) überlagert ist.

3. Speicherzelle nach Anspruch 2,
dadurch gekennzeichnet, daß das genannte isolierte flottierende Gate (GF) das Steuer-Gate vollständig umgibt.

4. Speicherzelle nach einem der Ansprüche 1 bis 3,
dadurch gekennzeichnet, daß die Isolierschicht unter dem flottierenden Gate aus Siliziumoxid mit einer Dicke im Bereich zwischen 8 und 12 nm besteht.

5. Speicherzelle nach Anspruch 4,
dadurch gekennzeichnet, daß die genannte Dicke der Isolierschicht etwa 10 nm beträgt.

6. Speicherzelle nach Anspruch 4,
dadurch gekennzeichnet, daß die Isolierschicht unter dem Steuer-Gate aus Siliziumoxid mit einer im wesentlichen doppelt so großen Dicke als die Isolierschicht unter dem flottierenden Gate besteht.

7. Verfahren zur Programmierung einer Speicherzelle nach einem der Ansprüche 1 bis 6,
dadurch gekennzeichnet, daß man Drain, Source und Substrat an Masse legt und an das Steuer-Gate einen Spannungsimpuls anlegt, der im Falle eines Substrats vom P-Typ ein positiver Spannungsimpuls ist.

8. Verfahren zum Löschen einer Speicherzelle gemäß einem der Ansprüche 1 bis 6,
dadurch gekennzeichnet, daß man Drain, Source und Substrat an Masse legt und an das Steuer-Gate einen Spannungsimpuls anlegt, der im Falle eines Substrats vom P-Typ negativ ist.

9. Verfahren zum Löschen einer Speicherzelle nach einem der Ansprüche 1 bis 6,
dadurch gekennzeichnet, daß man das Steuer-Gate und das Substrat an Masse legt und an Drain und Source einen Spannungsimpuls anlegt, der im Falle eines Substrats vom P-Typ positiv ist.

10. Verfahren zur Herstellung einer elektrisch programmierbaren Speicherzelle nach einem der Ansprüche 1 bis 6, dadurch gekennzeichnet, daß es die folgenden Verfahrensschritte umfaßt:
- Abgrenzen eines aktiven Bereichs auf einem Halbleitersubstrat (21), Überziehen dieses aktiven Bereichs mit einem Gate-Oxid (23) und Abgrenzen eines Gate-Bereichs (24) im wesentlichen in der Mitte des genannten aktiven Bereichs,
- Entfernen des Gate-Oxids (23) überall, ausgenommen unter dem Gate-Bereich (24),
- Erzeugen einer dünnen Oxidschicht (25) auf dem Substrat und auf dem und um das Gate herum (24),
- Implantation eines Dotierungsstoffs vom zweiten Leitfähigkeitstyp mit geringem Dotierungspegel,
- Herstellen von Abstandsteilen (28, 29) aus Leitermaterial zu beiden Seiten des Gates, sowie
- Implantation einer Source- und einer Drain-Dotierung vom zweiten Leitfähigkeitstyp mit hohem Dotierungspegel.

11. Verfahren nach Anspruch 10,
dadurch gekennzeichnet, daß es als weiteren Verfahrensschritt die Beseitigung eines Abstandsteils auf einer Seite des Gates umfaßt.

12. Verfahren nach Anspruch 10,
dadurch gekennzeichnet, daß der Verfahrensschritt der Implantation einer Dotierung mit niedrigem Dotierungspegel dem Verfahrensschritt der Entfernung des Gate-Oxids und dem Verfahrensschritt der Bildung der dünnen Oxidschicht vorhergeht oder auf sie folgt.

13. Verfahren nach Anspruch 10,
dadurch gekennzeichnet, daß das Steuer-Gate und die Abstandsteile aus dotiertem polykristallinem Silizium bestehen.

14. Verfahren nach Anspruch 10,
dadurch gekennzeichnet, daß die dünne Oxidschicht (25) durch thermische Oxidation bis zu einer Tiefe im Bereich zwischen 8 und 12 nm erzeugt wird.

## Claims

1. An electrically programmable cell comprising, over a channel region (11) of the first conductivity type, a control gate (GC) and , on both sides of the channel region, a source region (12) and a drain region (13) of a second conductivity type, at least the drain region including a low-doped region (14) adjacent to the channel, a floating gate (GF) covering at least a portion of said low-doped region, and being formed exclusively over this portion, characterized in that the thickness of the insulator under the floating gate is lower than the thickness of the insulator under the control gate and is low enough for injecting charge carriers through tunnel effect.

2. The memory cell of claim 1, characterized in that the source region also includes, near the channel, a low doped area (26), wherein said low doped area (26) is also at least partially covered with said insulated floating gate (GF).

3. The memory cell of claim 2, characterized in that said floating gate (GF) entirely surrounds the control gate.

4. The memory cell of any of claims 1 to 3, characterized in that the insulation layer beneath the floating gate is made of silicon oxide having a thickness ranging from 8 nm to 12 nm.

5. The memory cell of claim 4, characterized in that said thickness is approximately 10 nm.

6. The memory cell of claim 4, characterized in that the insulation layer of the control gate is made of silicon oxide having approximately twice the thickness of the insulation layer under the floating gate.

7. A process for programming a memory cell according to any of claims 1 to 6, characterized in that it consists in connecting the drain, the source and the substrate to ground and applying a voltage pulse to the control gate, positive if the substrate is of the P-type.

8. A process for erasing a memory cell according to any of claims 1 to 6, characterized in that it consists in connecting the drain, the source and the substrate to ground and applying a voltage pulse to the control gate, negative if the substrate is of the P-type.

9. A process for erasing a memory cell according any of claims 1 to 6, characterized in that it consists in connecting the control gate and the substrate to ground and applying a voltage pulse to the drain and the source, positive if the substrate is of the P-type.

10. A process for manufacturing an EPROM cell according to any of claims 1 to 6, characterized in that it includes the following steps:
delineating an active region on a conductive substrate (21), coating said active region with a gate oxide (23) and delineating a gate region (24) substantially in the middle of said active region,
etching away the gate oxide (23) except beneath the gate region (24),
forming a thin oxide layer(25) on the substrate, over and around the gate (24),
implanting a dopant of a second conductivity type with a low doping level,
forming spacers (28, 29) made of a conductive material on both sides of the gate, and
implanting a source and drain dopant of the second conductivity type with a high doping level.

11. The process of claim 10, characterized in that it further includes the step of eliminating a spacer on one side of the gate.

12. The process of claim 10, characterized in that the step of implanting a dopant having a low doping level precedes or follows the step of removing the gate oxide and the step of forming the thin oxide layer.

13. The process of claim 10, characterized in that the control gate and the spacers are made of doped polysilicon.

14. The process of claim 10, characterized in that the thin oxide layer (25) is formed by thermal oxidation up to a thickness ranging from 8 nm to 12 nm.
